# EUROPEAN PATENT SPECIFICATION

(11) **EP 3 014 672 B1**
(45) Date of publication and mention of the grant of the patent: **20.10.2021**
(21) Application number: 14817304.0
(22) Date of filing: 27.06.2014
(51) Int. Cl.: B32B 37/12, H01L 51/44, B32B 38/18, B29C 63/02

(54) **COATINGS FOR AIRCRAFT WINDOW SURFACES TO PRODUCE ELECTRICITY FOR MISSION-CRITICAL SYSTEMS AND MAINTENANCE LOAD ON COMMERCIAL AIRCRAFT**
BESCHICHTUNGEN FÜR FLUGZEUGFENSTEROBERFLÄCHEN ZUR ERZEUGUNG VON ELEKTRIZITÄT FÜR MISSIONSKRITISCHE SYSTEME UND WARTUNGSLAST BEI EINEM PASSAGIERFLUGZEUG
REVÊTEMENTS POUR SURFACES DE HUBLOT D'AVION CONÇUS POUR PRODUIRE DE L'ÉLECTRICITÉ POUR DES SYSTÈMES VITAUX ET UNE CHARGE D'ENTRETIEN SUR DES AVIONS COMMERCIAUX

(30) Priority: 28.06.2013 US 201361841248 P; 28.06.2013 US 201361841243 P; 28.06.2013 US 201361841247 P; 28.06.2013 US 201361841251 P; 28.06.2013 US 201361841244 P; 02.07.2013 US 201361842372 P; 02.07.2013 US 201361842357 P; 02.07.2013 US 201361842365 P; 02.07.2013 US 201361842355 P; 02.07.2013 US 201361842375 P; 03.07.2013 US 201361842796 P; 03.07.2013 US 201361842803 P
(43) Date of publication of application: 04.05.2016
(73) Proprietor: New Energy Technologies, Inc., Columbia, MD 21044 (US); Conklin, John, Anthony, Apalachin, NY 13732 (US); Hammond, Scott, Ryan, Wheat Ridge, CO 80215 (US); Thompson, J., Patrick, Canton, GA 30114 (US)
(72) Inventor: CONKLIN, John, Anthony, Apalachin, NY 13732 (US); HAMMOND, Scott, Ryan, Wheat Ridge, CO 80215 (US); THOMPSON, J., Patrick, Canton, GA 30114 (US)
(74) Representative: Schwegman Lundberg Woessner Limited
(86) International application number: PCT/US2014/044646
(87) International publication number: WO 2014/210503

(56) References cited:
- EP-B1- 2 311 101
- US-A- 3 092 250
- US-A- 4 699 335
- US-A1- 2008 295 889
- US-A1- 2009 229 667
- US-B2- 8 353 137
- KALTENBRUNNER M ET AL: "Ultrathin and lightweight organic solar cells with high flexibility", NATURE COMMUNICATIONS, NATURE PUBLISHING GROUP, UNITED KINGDOM , 3 April 2012 (2012-04-03), pages 1-7, XP002682520, ISSN: 2041-1723, DOI: 10.1038/NCOMMS1772 Retrieved from the Internet: URL:http://www.nature.com/ncomms/journal/v 3/n4/full/ncomms1772.html [retrieved on 2012-04-03]
- None

## Description

### FIELD OF THE INVENTION

The present invention is directed to the use of semi-transparent organic photovoltaic devices - cell or modules - as coatings for commercial aircraft windows, including cockpits, to provide electricity for mission-critical systems as well as maintenance loads on-board the aircraft.

### BACKGROUND OF THE INVENTION

Modern commercial aircraft are becoming increasingly technologically advanced vehicles that must operate effectively under demanding conditions. Energy efficiency and energy consumption are of increasing importance in such vehicles, as airlines and society become more concerned with both the economics and the climate impact of air travel. US 2009/0229667 A1 does not disclose application of an electricity-generating coating onto a window surface of an aircraft by means of a pressure-sensitive adhesive.

### SUMMARY OF THE INVENTION

The present invention recognizes that one way to increase energy efficiency is to incorporate renewable energy sources, but of the traditional renewable energy sources, photovoltaics (PV) is the only one that makes sense for aircraft. Electricity from PV could be used to help power mission-critical systems and/or maintenance loads on-board commercial aircraft to offset the energy needs of the many electrical systems present in rn aircraft. Traditional inorganic PV makes little sense for aircraft applications for a number of reasons, however, including excessive weight and potentially bulky structures that could increase wind resistance, both of which would reduce fuel efficiency, and poor aesthetics.

Organic PV (OPV) has a number of features that makes it potentially attractive for application in commercial aircraft including low specific weight (W/g), flexibility, and thickness of the thin films. The most important of these features is the very low specific weight of OPV, as compared to other PV technologies, which could minimize any impact on fuel efficiency. While OPV could potentially be applied to any external surface of a commercial aircraft, these surfaces must meet specific performance characteristics, and electrical wiring to utilize the power might prove complicated. If OPV could be placed on the inside of the aircraft, it would simplify the application and wiring of the devices, and reduce the exposure of the OPV materials to harsh environmental and flight conditions. Of course, the only place inside of the aircraft with significant solar light exposure is the windows. Traditional inorganic PV is generally opaque, which would eliminate the window effect, and the few inorganic PV technologies that can be made semitransparent suffer from numerous drawbacks, including high specific weight, high costs, low visible light transmission (VLT) and poor aesthetics.

SolarWindow™ is a novel PV window technology, based upon organic photovoltaics (OPV), that is the subject of several separate patent filings. This technology has numerous benefits, including the ability to generate power yet retain a high level of VLT in an attractive window application. To date, however, it has only been considered for terrestrial applications, generally in building-integrated PV applications. In addition to the very low specific weight (W/g), OPV is inherently flexible and thin, which potentially allows unique application methods for non-planar surfaces, such as cockpit and fuselage windows. Furthermore, the tunable nature of light absorption in OPV materials allows customized appearance and performance in semi-transparent window applications, which would allow performance and aesthetics to be optimized for different windows inside a commercial aircraft (e.g. cockpit vs. passenger windows).

The present invention recognizes that conventional commercial aircraft windows are strictly passive windows, which do not contribute in any way to help increase energy efficiency of the aircraft.

These problems and others are addressed by the present invention as defined in the appended claims. An exemplary embodiment of the electricity-generating coating can be applied as a coating to a conventional commercial aircraft window. The coating can be applied to either the exterior or interior of the aircraft window, depending on the desired properties, but the interior coating likely has significant benefits, including increased protection of the OPV module and easier electrical connections. In this embodiment, the OPV device can either be applied as a completed device onto the window surface using a thin, flexible substrate with pressure-sensitive adhesives, which is described in detail Applicants' related applications, or OPV device can be fabricated directly on the window through standard coating (e.g. spray, slot-die, curtain, gravure, etc.) and processing (e.g. laser scribing) techniques, as known to those skilled in the art of OPV. The OPV or SolarWindow™ device can provide electricity to help power mission-critical systems and/or maintenance loads on-board the aircraft, while still retaining a high degree of VLT and attractive aesthetics to ensure good visibility and passenger comfort.

Another exemplary embodiment of the invention can be applied as a coating to a conventional commercial aircraft cockpit or fuselage window. Again, the coating may be applied to either the inside or the outside, with the inside having significant advantages, as described previously. In this embodiment, the OPV or SolarWindow™ device can again provide electricity to help power mission-critical systems and/or maintenance loads, while still retaining a high degree of VLT to ensure good visibility. The absorption of the OPV module can be selected to yield optimal visual transmission properties of the window to aid in pilot perception, while still generating power. Furthermore, while the OPV device can be fabricated directly on the window through the use of complicated three-dimensional coating (spray, slot-die, curtain, gravure, etc.) and processing (e.g. laser scribing) methods, the inherent flexibility of OPV also presents the potential for application of the completed OPV module to the cockpit canopy and fuselage windows through the use of thin, flexible substrates and pressure-sensitive adhesives, which is described in Applicants' related applications.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:
Figure 1 is a cross-sectional view of a pressure-sensitive adhesive-coated, semitransparent organic photovoltaic device, itself coated on a thin flexible substrate with a transfer release layer and rigid backing layer, which can be used to prepare planar and curved organic photovoltaic device-covered commercial aircraft windows, according to an exemplary embodiment of this invention.
Figure 2 is a cross-sectional view of a semitransparent organic photovoltaic device coated onto a planar commercial aircraft window using the pressure-sensitive adhesive method according to an exemplary embodiment of the invention.
Figure 3 is a cross-sectional view of a semitransparent organic photovoltaic device coated onto a planar commercial aircraft window using conventional coating methods according to an exemplary embodiment of the invention.
Figure 4 is a cross-sectional view of a semitransparent organic photovoltaic device coated onto a curved commercial aircraft window using the pressure-sensitive adhesive method according to an exemplary embodiment of the invention.
Figure 5 is a cross-sectional view of a semitransparent organic photovoltaic device coated onto a curved commercial aircraft window using conventional coating methods according to an exemplary embodiment of the invention.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

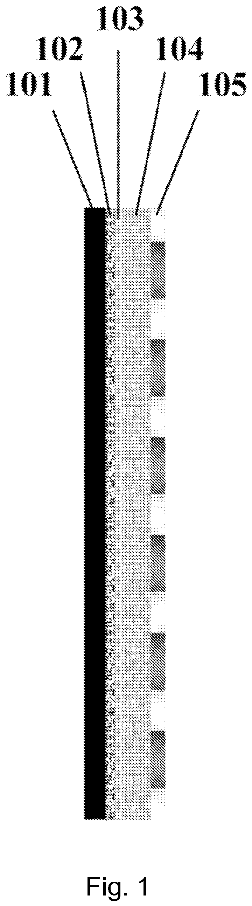

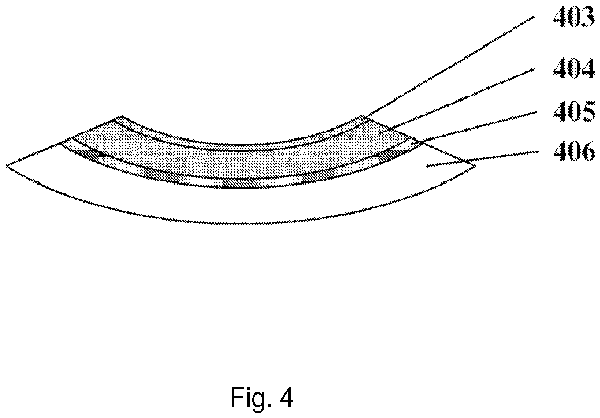

Referring now to the drawings, Figures 1-5 illustrate exemplary embodiments of electricity-generating coatings for commercial aircraft window surfaces (Figures 4-5) and their manufacture (Figure 1).

Referring to Fig. 1, which provides a cross-sectional view of an intermediate film stack produced for the eventual fabrication of electricity-generating coatings for commercial aircraft window surfaces, the film is prepared upon a temporary base layer 101, in order to provide sufficient rigidity to allow conventional manufacturing techniques, including high-speed roll-to-roll coating. The base layer can include of thick polymer foils, metal foils, or any convenient substrate material, depending on the chosen manufacturing methods. On top of the base layer is a transfer release layer 102 that allows easy removal of the base layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated a semi-transparent OPV device, comprising one or more cells connected in series and/or parallel, which is inherently flexible and thus contains no highly crystalline materials. The multi-layered OPV device is coated and processed according to standard methods known to those skilled in the art, such as slot-die coating and laser scribing, which are compatible with high-throughput manufacturing techniques, including high-speed roll-to-roll or sheet-to-sheet production methods. Finally, the OPV device is coated on top with a semitransparent pressure-sensitive adhesive according to methods know to those skilled in the art. The resulting film comprising layers 101-105 can be used to transfer the semitransparent OPV device comprising layers 103-105 onto commercial aircraft windows to convert them into electricity-generating window surfaces.

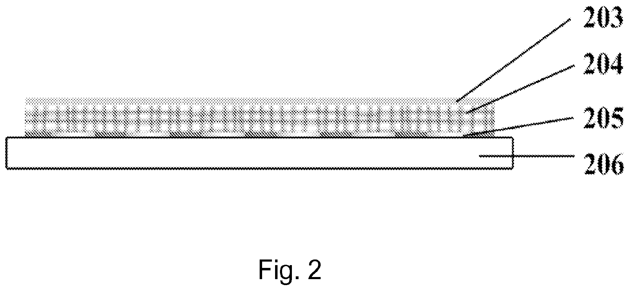

Referring to Fig. 2, which provides a cross-sectional view of a planar electricity-generating commercial aircraft window produced via the pressure-sensitive adhesive method, the base layer 206 includes a conventional commercial aircraft window. Laminated onto the window using stretching and press-forming, with or without vacuum assistance in removing entrained air, is the electricity-generating semitransparent OPV device 204, which is adhered to the window using the pressure-sensitive adhesive layer 205, and is supported by the thin flexible substrate layer 203. While this method is necessarily a discrete object process for the fabrication of each individual window, the intermediate transfer film (see Fig. 1) used to transfer the completed OPV device onto the window can be produced in a continuous, high-throughput methodology. Not shown are any wires or other electrical contacts, or any power circuitry (e.g. inverters), which would be contained within the window casing or aircraft body, respectively, or any protective coatings that might be desirable.

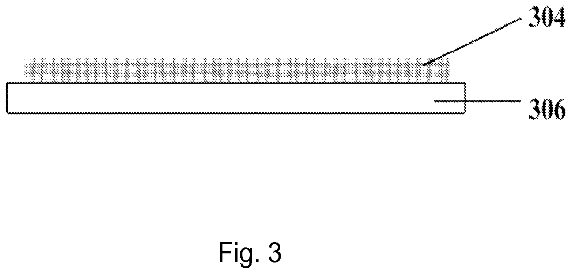

Referring to Fig. 3, which provides a cross-sectional view of a planar electricity-generating commercial aircraft window produced via the conventional coating method, the base layer 306 includes a conventional commercial aircraft window. The semitransparent OPV device 304 is coated directly onto the window surface using conventional coating techniques such as known to those skilled in the art. While this method has the advantage of having less extraneous layers and materials involved as compared to the laminated processes (see Fig. 2), it is necessarily a sheet-to-sheet coating process performed on a window-by-window basis for every individual layer in the OPV device, which can limit throughput and increase defects, compared to producing the OPV device in a continuous process (see Fig. 1). Not shown are any wires or other electrical contacts, or any power circuitry (e.g. inverters), which would be contained within the window casing or aircraft body, respectively, or any protective coatings that might be desirable.

Referring to Fig. 4, which provides a cross-sectional view of a curved electricity-generating commercial aircraft window (e.g. cockpit window) produced via the pressure-sensitive adhesive method, the base layer 406 includes a conventional curved commercial aircraft window (e.g. cockpit window). Laminated onto the window using stretching and press-forming, with or without vacuum assistance in removing entrained air, is the electricity-generating semitransparent OPV device 404, which is adhered to the window using the pressure-sensitive adhesive layer 405, and is supported by the thin flexible substrate layer 403. The unique and inherent flexibility of OPV devices allows lamination onto curved surfaces without significant disruption of device performance, and enables production of three-dimensional OPV devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While this method is necessarily a discrete object process for the fabrication of each individual window, the intermediate transfer film (see Fig. 1) used to transfer the completed OPV device onto the window can be produced in a continuous, high-throughput methodology. Not shown are any wires or other electrical contacts, or any power circuitry (e.g. inverters), which would be contained within the window casing or aircraft body, respectively, or any protective coatings that might be desirable.

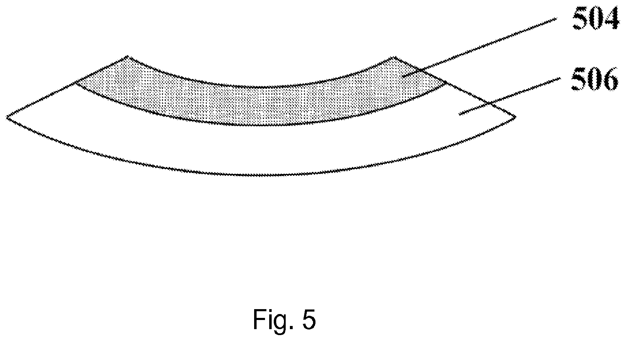

Referring to Fig. 5, which provides a cross-sectional view of a curved electricity-generating commercial aircraft window (e.g. cockpit window) produced via the conventional coating method, the base layer 506 includes a conventional curved commercial aircraft window (e.g. cockpit window). The semitransparent OPV device 504 is coated directly onto the window surface using conventional coating techniques such as spray or curtain coating. While the realities of capillarity flow make precision coating of such very thin layers very difficult, it is possible to overcome these limitations, as least for surfaces with relatively uniform curvature. Doing so repeated for the several layers in a semitransparent OPV device remains a significant challenge, however, and it is currently impossible for surfaces with varying or very high curvature. As such, the pressure-sensitive adhesive lamination method presents an attractive alternative for the production of curved windows (see Fig. 4).

The present invention has been described herein in terms of several preferred embodiments. However, modifications and additions to these embodiments will become apparent to those of ordinary skill in the art upon a reading of the foregoing description. It is intended that all such modifications and additions comprise a part of the present invention to the extent that they fall within the scope of the several claims appended hereto.

## Claims

1. An electricity-generating coating for a window surface of a commercial aircraft, the electricity-generating coating comprising:
a conformal organic photovoltaic device (204, 304), including one or more cells connected in series and/or parallel, wherein the conformal organic photovoltaic device is configured to be adhered to the window surface, along with wires and power electronics to allow the coating to provide electricity for an electrical load on-board the commercial aircraft;
a pressure-sensitive adhesive (205, 305) on the conformal organic photovoltaic device, the pressure-sensitive adhesive being capable of adhering the conformal organic photovoltaic device to the window surface,
wherein the organic photovoltaic device is semitransparent and the pressure-sensitive adhesive is one of semitransparent and transparent such that light is capable of passing through the electricity-generating coating from either side to provide visibility through the window surface while the electricity-generating coating generates the electricity; and
a very thin, highly flexible transparent substrate (203, 303),
wherein the conformal organic photovoltaic device is covered by the very thin, highly flexible transparent substrate.

2. The electricity-generating coating of claim 1, wherein the conformal organic photovoltaic device is protected by a transparent encapsulant material.

3. The electricity-generating coating of claim 2, wherein the window surface comprises a planar surface.

4. The electricity-generating coating of claim 2, wherein the window surface comprises a curved surface.

5. The electricity-generating coating of claim 1, wherein the conformal organic photovoltaic device is configured to be coated directly on the three-dimensional window surface.

6. The electricity-generating coating of claim 5, wherein the conformal organic photovoltaic device is protected by a transparent encapsulant material.

7. The electricity-generating coating of claim 6, wherein the window is completely planar.

8. The electricity-generating coating of claim 6, wherein the window surface comprises a curved surface.

## Patentansprüche

1. Elektrizitätserzeugende Beschichtung für eine Fensteroberfläche eines Verkehrsflugzeugs, wobei die elektrizitätserzeugende Beschichtung umfasst:
eine konforme organische photovoltaische Vorrichtung (204, 304), die eine oder mehrere Zellen umfasst, die in Reihe und/oder parallel geschaltet sind, wobei die konforme organische photovoltaische Vorrichtung dafür eingerichtet ist, zusammen mit Drähten und Leistungselektronik an die Fensteroberfläche geklebt zu werden, damit die Beschichtung Elektrizität für eine elektrische Last an Bord des Verkehrsflugzeugs bereitstellen kann;
einen drucksensitiven Klebstoff (205, 305) auf der konformen organischen photovoltaischen Vorrichtung, wobei der drucksensitive Klebstoff in der Lage ist, die konforme organische photovoltaische Vorrichtung an die Fensteroberfläche zu kleben,
wobei die organische photovoltaische Vorrichtung semitransparent ist und der drucksensitive Klebstoff entweder semitransparent oder transparent ist, so dass Licht die elektrizitäterzeugende Beschichtung von beiden Seiten durchdringen kann, um eine Sicht durch die Fensteroberfläche hindurch zu ermöglichen, während die elektrizitäterzeugende Beschichtung die Elektrizität erzeugt; und
ein sehr dünnes, hochflexibles transparentes Substrat (203, 303),
wobei die konforme organische photovoltaische Vorrichtung durch das sehr dünne, hochflexible transparente Substrat bedeckt ist.

2. Elektrizitäterzeugende Beschichtung nach Anspruch 1, wobei die konforme organische photovoltaische Vorrichtung durch ein transparentes Verkapselungsmaterial geschützt ist.

3. Elektrizitäterzeugende Beschichtung nach Anspruch 2, wobei die Fensteroberfläche eine planare Oberfläche umfasst.

4. Elektrizitäterzeugende Beschichtung nach Anspruch 2, wobei die Fensteroberfläche eine gekrümmte Oberfläche umfasst.

5. Elektrizitäterzeugende Beschichtung nach Anspruch 1, wobei die konforme organische photovoltaische Vorrichtung dafür eingerichtet ist, direkt auf die dreidimensionale Fensteroberfläche beschichtet zu werden.

6. Elektrizitäterzeugende Beschichtung nach Anspruch 5, wobei die konforme organische photovoltaische Vorrichtung durch ein transparentes Verkapselungsmaterial geschützt ist.

7. Elektrizitäterzeugende Beschichtung nach Anspruch 6, wobei das Fenster vollständig planar ist.

8. Elektrizitäterzeugende Beschichtung nach Anspruch 6, wobei die Fensteroberfläche eine gekrümmte Oberfläche umfasst.

## Revendications

1. Revêtement générateur d'électricité pour surface de hublot d'un aéronef commercial, le revêtement générateur d'électricité comprenant :
un dispositif photovoltaïque organique conformé (204, 304) comportant une ou plusieurs cellules connectées en série et/ou en parallèle, dans lequel le dispositif photovoltaïque organique conformé est conçu pour adhérer à la surface de hublot, conjointement avec des fils et électronique de puissance pour permettre au revêtement de fournir de l'électricité destinée à une charge électrique à bord de l'aéronef commercial ;
un adhésif sensible à la pression (205, 305), sur le dispositif photovoltaïque organique conformé, l'adhésif sensible à la pression étant apte à faire adhérer le dispositif photovoltaïque organique conformé à la surface de hublot,
dans lequel le dispositif photovoltaïque organique est semi-transparent et l'adhésif sensible à la pression est semi-transparent ou transparent de manière que la lumière puisse passer à travers le revêtement générateur d'électricité d'un côté ou de l'autre pour assurer une visibilité à travers la surface de hublot tandis que le revêtement générateur d'électricité produit l'électricité ; et
un substrat transparent très mince, hautement flexible (203, 303),
dans lequel le dispositif photovoltaïque organique conformé est recouvert par le substrat transparent très mince, hautement flexible.

2. Revêtement générateur d'électricité, selon la revendication 1, dans lequel le dispositif photovoltaïque organique conformé est protégé par un matériau d'enrobage transparent.

3. Revêtement générateur d'électricité, selon la revendication 2, dans lequel la surface de hublot comprend une surface plane.

4. Revêtement générateur d'électricité, selon la revendication 2, dans lequel la surface de hublot comprend une surface incurvée.

5. Revêtement générateur d'électricité, selon la revendication 1, dans lequel le dispositif photovoltaïque organique conformé est conçu pour être appliqué directement sur la surface tridimensionnelle de hublot.

6. Revêtement générateur d'électricité, selon la revendication 5, dans lequel le dispositif photovoltaïque organique conformé est protégé par un matériau d'enrobage transparent.

7. Revêtement générateur d'électricité, selon la revendication 6, dans lequel le hublot est complètement plan.

8. Revêtement générateur d'électricité, selon la revendication 6, dans lequel la surface de hublot comprend une surface incurvée.
